# EUROPEAN PATENT SPECIFICATION

(11) **EP 4 719 004 B1**
(45) Date of publication and mention of the grant of the patent: **18.11.2026**
(21) Application number: 25164323.5
(22) Date of filing: 18.03.2025
(51) Int. Cl.: H10F 71/00, H10F 77/20

(54) **METHOD FOR MANUFACTURING SOLAR CELL**
VERFAHREN ZUR HERSTELLUNG EINER SOLARZELLE
PROCÉDÉ DE FABRICATION DE CELLULE SOLAIRE

(30) Priority: 25.09.2024 CN 202411346368
(43) Date of publication of application: 01.04.2026
(73) Proprietor: Jinko Solar Co., Ltd., Jiangxi 334100 (CN); Zhejiang Jinko Solar Co., Ltd., Haining, Zhejiang 314416 (CN)
(72) Inventor: ZHENG, Peiting, Shangrao, 334100 (CN); SHEN, Mengchao, Shangrao, 334100 (CN); CHEN, Xuefeng, Shangrao, 334100 (CN); JIANG, Chuanwei, Shangrao, 334100 (CN); WANG, Zhao, Shangrao, 334100 (CN); YANG, Jie, Shangrao, 334100 (CN); ZHANG, Xinyu, Shangrao, 334100 (CN)
(74) Representative: Haseltine Lake Kempner LLP

(56) References cited:
- CN-A- 116 705 903
- CN-A- 116 825 886
- CN-A- 118 039 740
- CN-A- 118 398 715
- CN-A- 118 522 789

## Description

### TECHNICAL FIELD

The present application relates to the technical field of solar cells, and in particular, to a method for manufacturing a solar cell.

### BACKGROUND

Solar cells are devices converting light energy of the sun to electric energy. The solar cells generate carriers based on photovoltaic principle and then lead carriers out by means of electrodes, which is beneficial to an effective use of the electric energy. However, the conversion efficiencies of the existing solar cells need to be further improved. Documents CN118039740A and CN116825886A disclose a solar cell manufacturing process and a solar cell.

### SUMMARY

In view of this, it is necessary to provide a method for manufacturing solar cell to at least improve a conversion efficiency of the solar cell.

The present application provides a method for manufacturing solar cell according to claim 1.

In an embodiment, the number of times the laser is controlled to perform the continuous moving irradiation on the solar cell substrate is at least three times; the continuous moving irradiation processes other than the first continuous moving irradiation process are all target irradiation processes; in all target irradiation processes, moving directions of lasers moving on the solar cell substrate constitute a moving direction set. In the moving direction set, there are a plurality of moving directions being the same, or a plurality of moving directions being opposite. Or in the moving direction set, there are a plurality of moving directions intersecting with each other.

In an embodiment, a reverse bias voltage of the laser in the first continuous moving irradiation process is greater than a reverse bias voltage of a laser in any one of the continuous moving irradiation processes other than the first continuous moving irradiation process; and/or a power of the laser in the first continuous moving irradiation process is greater than a power of the laser in any one of the continuous moving irradiation processes other than the first continuous moving irradiation process; and/or the laser used in any one of the continuous moving irradiation processes other than the first continuous moving irradiation process is configured as a red laser.

In an embodiment, an irradiation region formed in each of the continuous moving irradiation processes is the same region.

In an embodiment, there are a plurality of different irradiation regions among irradiation regions formed by all of the continuous moving irradiation processes.

In an embodiment, there is a first target region among all of the irradiation regions. The first target region is determined based on the position where the first initial electrode is located.

In an embodiment, there is a second target region among all of the irradiation regions. The second target region is determined based on a corresponding region on a side surface of the solar cell substrate where the first electrode is located, and the corresponding region comprises at least one of a poorly sintered region of the first initial electrode and an edge region of the solar cell substrate.

In an embodiment, an order of all of the irradiation regions, which are formed by all of the continuous moving irradiation processes performed in an order, is preset. A sorting number corresponding to the second target region is an intermediate number. Or the sorting number corresponding to the second target region is the first number. Or the sorting number corresponding to the second target region is the last number.

In an embodiment, in the target irradiation process, an angle formed by the moving direction of the laser and the longitudinal extension direction of the first electrode is in a range from 45° to 135°; and/or a reverse bias voltage of the laser is in a range from 10V to 30V, a power of the laser is in a range from 10W to 100W, and a scanning speed of the laser is in a range from 20000 mm/s to 200000 mm/s; and/or an irradiation region formed by each of the continuous moving irradiation processes is continuously extended or discontinuously extended; and/or the number of times the laser is controlled to perform the continuous moving irradiation on the solar cell substrate is twice.

In an embodiment, the solar cell substrate includes a base, a doped layer, a first passivation layer, a tunneling layer, a doped conductive layer and a second passivation layer. The base has dopant elements therein; the base has a first surface and a second surface; the doped layer and the first passivation layer are arranged on the first surface of the base in sequence; and the tunnelling layer, the doped conductive layer and the second passivation layer are arranged on the second surface of the base in sequence.

In an embodiment, controlling the laser to perform the continuous moving irradiation on the solar cell substrate, and performing the laser-assisted sintering treatment on the first initial electrode to form the first electrode and obtain the solar cell, including: providing a laser device, the laser device being located at a side of the solar cell substrate in the thickness direction of the solar cell substrate and arranged opposite to a central region of the solar cell substrate; and controlling the laser device to rotate, so that a moving irradiation region of the laser emitted by the laser device covers at least a portion of the solar cell substrate to perform the laser-assisted sintering treatment on the first initial electrode to form the first electrode.

In the methods for manufacturing solar cell above, after the first initial electrode is formed by the metallization heat treatment process, the laser-assisted sintering treatment is performed on the first initial electrode to form the first electrode and obtain the solar cell. In this process, through configuring the target irradiation process in the laser-assisted sintering treatment, the moving direction of the laser moving on the solar cell substrate in the target irradiation process and the longitudinal extension direction of the first electrode intersect with each other. Such that, on one hand, a portion of the irradiation region formed by the laser in the target irradiation process covers the electrode region of the solar cell, thereby improving the contact performance between the first electrode and the substrate, and on the other hand, another portion of the irradiation region formed by the laser in the target irradiation process covers the non-electrode region of the solar cell, thereby exciting carriers by means of the assistance of the non-electrode region. When a certain reverse bias voltage is applied, these excited charge carriers will move directionally to generate a local current. This local current may further cause the temperature of the sintered region to rise, thus promoting further mutual fusion and diffusion of the first initial electrode and the substrate, thereby further improving the contact performance between the formed first electrode and the substrate. Compared with the method in which the moving direction of the laser is parallel to the longitudinal extension direction of the first electrode and the laser acts on the first initial electrode or on a region adjacent to the first initial electrode to perform the laser-assisted sintering, the laser described above can not only form a larger range covering the non-electrode region in the target irradiation process, thereby exciting more carriers and significantly improving the contact performance between the formed first electrode and the substrate, but also reduce the requirement for controlling the alignment accuracy of the laser, thereby expanding a process window and improving the manufacturing efficiency as well. Therefore, by configuring the target irradiation process above, not only can the contact performance between the first electrode and the substrate can be improved, thus improving the conversion efficiency of the solar cell, but also the solar cell is easy to be processed and manufactured, and the manufacturing efficiency is improved.

Additional aspects and advantages of the embodiments of the present application will be described in part in the description below, and other part will become apparent from the description below or will be learned from the implements of the embodiments of the present application.

### BRIEF DESCRIPTION OF THE DRAWINGS

Various additional advantages and benefits will become apparent to those of ordinary skill in the art from reading the following detailed description of the embodiments. The drawings are only for the purpose of illustrating the embodiments but not to be considered as limitation on the present application. Moreover, throughout the drawings, the same reference numerals are used to denote the same parts. In the accompanying drawings:
FIG. 1 shows a flow chart of a method for manufacturing solar cell according to some embodiments of the present application;
FIG. 2 shows a schematic sectional view of a solar cell substrate according to some embodiments of the present application;
FIG. 3 shows a schematic structural view of the solar cell substrate shown in FIG. 2, with metal paste printed thereon;
FIG. 4 shows a schematic structural view of the solar cell substrate shown in FIG. 2, with first initial electrodes formed thereon;
FIG. 5 shows a schematic structural view of the solar cell substrate shown in FIG. 2, with first electrodes formed thereon;
FIG. 6 is a schematic view showing a laser irradiating on the solar cell substrate according to some embodiments of the present application;
FIG. 7 is a schematic view showing moving irradiation paths P according to some embodiments of the present application;
FIG. 8 is a schematic view showing the laser irradiating on the solar cell substrate according to some other embodiments of the present application;
FIG. 9 is a schematic view showing an irradiation region according to some embodiments of the present application;
FIG. 10 is a schematic view showing an irradiation region according to some other embodiments of the present application;
FIG. 11 is a schematic view showing irradiation regions on the solar cell substrate according to some embodiments of the present application;
FIG. 12 is a schematic view showing moving irradiation paths according to some other embodiments of the present application;
FIG. 13 is a schematic view showing moving irradiation paths according to some other embodiments of the present application;
FIG. 14 is a schematic view showing moving irradiation paths according to yet some other embodiments of the present application;
FIG. 15 is a schematic view showing a first target region on the solar cell substrate according to some embodiments of the present application;
FIG. 16 is a schematic view showing a second target region on the solar cell substrate according to some embodiments of the present application;
FIG. 17 is a schematic view showing moving irradiation paths according to yet some embodiments of the present application;
FIG. 18 is a flow chart showing step S130 of the method for manufacturing solar cell according to some embodiments of the present application;
FIG. 19 shows a schematic sectional view of a solar cell according to some embodiments of the present application.

Description of reference numerals:
solar cell 100;
solar cell substrate 110, base 111, first surface m1, second surface m2, doped layer 112, first passivation layer 113, tunneling layer 114, doped conductive layer 115, second passivation layer 116, first electrode E1, second electrode E2;
metal paste e0, first initial electrode e1;
laser device Q, laser L, moving irradiation path P, irradiation area W, first target area Z1, second target area Z2;
moving direction M, first angle *θ*, first direction F₁, second direction F₂, third direction F₃;
step S110, S120, S130, S131, S132.

### DETAILED DESCRIPTION OF THE EMBODIMENTS

In order to make the above objectives, features and advantages of the present application clearer and to be better understood, specific implementations of the present application are described in detail below with reference to the accompanying drawings. In the following description, many specific details are set forth to make the present application to be fully understood. However, the present application can be implemented in many other ways different from those described herein, and those skilled in the art can make similar improvements without departing from the connotation of the present application. Therefore, the present application is not limited by the specific embodiments disclosed below.

In the description of the present application, it should be understood that if the terms "center", "longitudinal", "transverse", "length", "width", "thickness", "upper", "lower", "front", "rear", "left", "right", "vertical", "horizontal", "top", "bottom", "inner", "outer", "clockwise", "counterclockwise", "axial", "radial", "circumferential", etc. appear, the orientation or position relationships indicated by these terms are based on the orientation or position relationships shown in the accompanying drawings and are merely intended to facilitate the description of the present application and simplify the description, rather than indicating or implying that the indicated device or element must have a particular orientation or be constructed and operated in a particular orientation, and therefore are not to be interpreted as limitation on the present application.

In addition, if the terms "first" and "second" appear, these terms are used for descriptive purposes only but cannot be interpreted as indicating or implying relative importance or implicitly specifying the number of indicated technical features. Thus, the features defined as "first" and "second" may explicitly or implicitly include at least one of these features. In the description of the present application, if the term "plurality" appears, the "plurality" means at least two, such as two, three, etc., unless otherwise clearly and specifically defined.

In the present application, unless otherwise clearly specified and limited, if the terms "mount", "connection", "communication", "fix", etc., appear, these terms should be understood in a broad sense, for example, may be a fixed connection or a detachable connection, or an integrated connection; or may be a mechanical connection or an electrical connection; or may be a direct connection or an indirect connection through an intermediate medium; or may be an internal communication between two elements or an interaction relationship between two elements, unless otherwise clearly defined. It is worth noting that, in the following description and the appended claims, one feature being electrically connected to another feature not only includes one feature being in direct contact with another feature to form an electric energy transmission or a current transmission channel, but also includes the case that there is an intermediate feature between the one feature and the other feature, and an electric energy transmission channel or a current transmission channel is formed by the feature, the other feature and the intermediate feature therebetween to achieve an electric energy transmission or delivery. Those of ordinary skill in the art can understand the specific meanings of the above terms in the present application according to specific situations.

In the present application, unless otherwise clearly specified and limited, if there is a description that a first feature is "above" or "under" a second feature, etc., or similar description, it may mean that the first and second features are in direct contact, or the first and second features are in indirect contact through an intermediate medium. Moreover, the first feature being "on top of", "above" and "over" the second feature may mean that the first feature is directly above or obliquely above the second feature, or simply means that the horizontal height of the first feature is greater than that of the second feature. The first feature being "under", "beneath" and "below" the second feature may mean that the first feature is directly below or obliquely below the second feature, or simply means that the horizontal height of the first feature is less than the second feature.

It should be noted that when an element is referred to as being "fixed on" or "disposed on" another element, the element may be directly on the other element, or there may be an intermediate element therebetween. When the element is referred to as being "connected to" another element, the element may be directly connected to the other element, or intermediate elements may also be provided. If present, the terms "vertical", "horizontal", "upper", "lower", "left", "right" and similar expressions used in this application are for the purpose of illustration only but are not meant to be the unique embodiment.

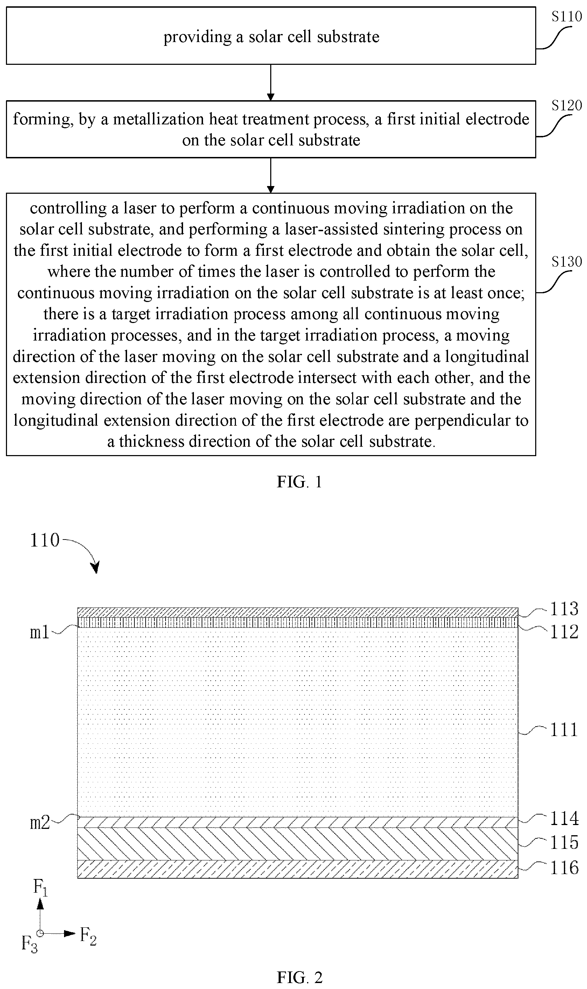

FIG. 1 is a flow chart of a method for manufacturing solar cell according to some embodiments of the present application. For purposes of illustration, only those relevant to embodiments of the present application are shown.

Referring to the FIG. 1, an embodiment of the present application provides a method for manufacturing solar cell, including the following steps:
Step S110, providing a solar cell substrate;
Step S120, forming, by a metallization heat treatment process, a first initial electrode on the solar cell substrate;
Step S130, controlling a laser to perform a continuous moving irradiation on the solar cell substrate, and performing a laser-assisted sintering treatment on the first initial electrode to form a first electrode and obtain the solar cell. Where the number of times the laser is controlled to perform a continuous moving irradiation on the solar cell substrate is at least once. There is a target irradiation process among all continuous moving irradiation processes, and in the target irradiation process, a moving direction of the laser moving on the solar cell substrate and a longitudinal extension direction of the first electrode intersect with each other, and the moving direction of the laser moving on the solar cell substrate and the longitudinal extension direction of the first electrode are perpendicular to a thickness direction of the solar cell substrate.

In step S110, referring to FIG. 2, FIG. 2 shows a schematic sectional view of a solar cell substrate according to some embodiments of the present application. The solar substrate 110 includes a base 111 and layer structures disposed on the base 111. Taking FIG. 2 as an example, in an embodiment of the present application, a first direction F₁ is the thickness direction of the base 111, a second direction F₂ and a third direction F₃ are a length direction and a width direction of the base 111 respectively. The first direction F₁, the second direction F₂ and the third direction F₃ are perpendicular to each other. It should be noted that, a dimension of the base 111 in the length direction may be greater than or equal to a dimension of the base 111 along the width direction, which is not specifically limited herein.

Specially, the base 111 has dopant elements therein, and the type of dopant elements is N-type or P-type. The base 111 has a first surface m1 and a second surface m2, which are oppositely arranged in the first direction F₁. The first surface m1 and the second surface m2 are oppositely disposed along the first direction F₁. Both the first surface m1 and the second surface m2 can be configured to receive incident light. In an embodiment of the present application, the first surface m1 of the base 111 is a light-receiving surface, and the second surface m2 of the base 111 is a backlight surface. It can be understood that the light-receiving surface and the backlight surface are relatively defined. The light-receiving surface is specifically a surface of the base 111 in the solar cell or in a photovoltaic module, which is mainly irradiated by sunlight. With the development of the technology of the solar cell, the backlight surface may also receive sunlight energy mainly from reflected light or scattered light from the surrounding environment.

A doped layer 112 and a first passivation layer 113 may be arranged on/at the first surface m1 of the base 111 in sequence, and a tunnelling layer 114, a doped conductive layer 115 and a second passivation layer 116 may be arranged on/at the second surface m2 of the base 111 in sequence, thus forming the solar cell substrate 110. The solar cell substrate 110 may constitute at least a portion of a Tunnel Oxide Passivating Contacts (TOPCon) cell. The layer structures arranged on the base 111 may be modified according to the actual usage requirements. In other embodiments, different layers or structures may be arranged on the first surface m1 and the second surface m2 of the base 111 according to specific usage requirements. For example, the solar cell substrate 110 may also be used to constitute at least a portion of a Back Contact (BC) cell. That is, the solar cell substrate 110 can be manufactured according to the actual usage requirements and used to constitute different types of solar cells, which is not specifically limited herein.

In step S120, the metallization heat treatment process may include a printing process and a sintering process. The printing process refers to a process in which metal paste is printed onto a corresponding region on the solar cell substrate. The printing process includes at least one of a screenprinting process, a gravure printing process, a letterpress printing process, a flexographic printing process, a laser transfer printing process, an inkjet printing process, or a 3D printing process. The sintering process refers to a heat treatment process that allows at least a portion of the metal paste to penetrate a corresponding layer structure on the solar cell substrate.

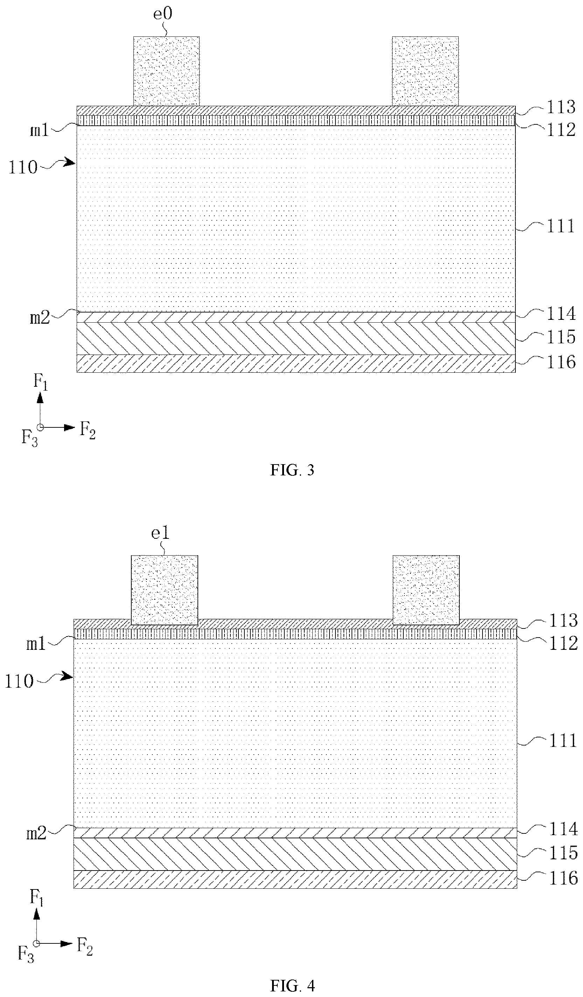

Taking FIG. 3 as an example, FIG. 3 shows a schematic structural view of the solar cell substrate shown in FIG. 2, with metal paste e0 printed thereon. The metal paste e0 is printed on a surface of the first passivation layer 113 away from the doped layer 112, and the region which the metal paste e0 is printed on may be determined according to the actual usage requirements and is not specifically limited herein. Referring to FIG. 4, FIG. 4 shows a schematic structural view of the solar cell substrate 110 shown in FIG. 2, with a first initial electrode e1 formed thereon. The sintering process is performed on the aforementioned metal paste e0, and at least a portion of the metal paste e0 is sintered into a partial thickness in the first passivation layer 113 to form the first initial electrode e1. In this case, at least a portion of the first initial electrode e1 is not in contact with the doped layer 112. Alternatively, at least a portion of the metal paste e0 penetrates the first passivation layer 113 to electrically contact the doped layer 112, forming the first initial electrode e1. In this case, at least a portion of the first initial electrode e1 is in contact with the doped layer 112. In this process, the metal paste e0 may be sintered in a sintering furnace. In some embodiments, one or more first initial electrodes e1 may be formed on the solar cell substrate 110. In some embodiments, the doped layer 112 may be formed as a portion of the base 111 by diffusing dopants into the base 111. In some embodiments, the doped layer 112 may be formed on the base 111 by depositing an individual layer with dopants.

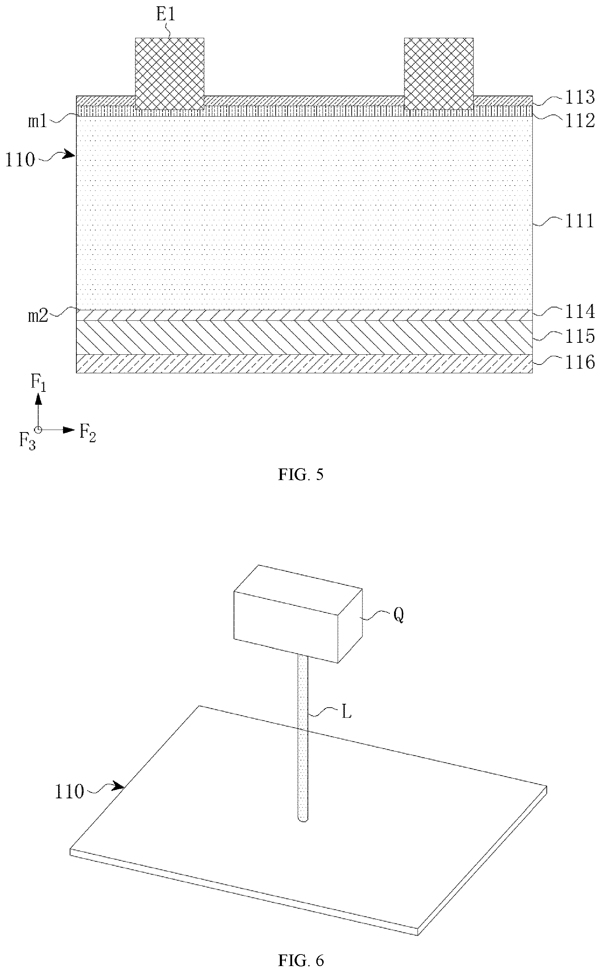

In step S130, the laser irradiates the solar cell substrate to form a light spot. A shape of the light spot includes, but is not limited to, a rectangle, a circle, an ellipse, or any other shape. During the motion of the laser, at least a majority of the region where the first initial electrode is located is covered by a region irradiated by the light spot. In this way, the first initial electrode can be subjected to a laser-assisted sintering treatment to form the first electrode by the moving irradiation of the laser. Referring to FIG. 5, FIG. 5 shows a schematic structural view of the solar cell substrate 110 shown in FIG. 2, with a first electrode E1 formed thereon. After the laser-assisted sintering treatment, the first initial electrode e1 forms the first electrode E1, and the first electrode E1 comes in ohmic contact with the doped layer 112. In this process, the laser may destroy a portion of the first passivation layer 113 in an electrode region, so that a portion of the first initial electrode e1 melts and diffuses and may further enter direct contact with the doped layer 112 to form tiny alloy junctions, thereby reducing a contact resistance and improving a transmission efficiency of electrons. The electrode region is a region where the first electrode E1 is arranged, and a non-electrode region is a region defined relative to the electrode region, and no first electrodes E1 are arranged in the non-electrode region.

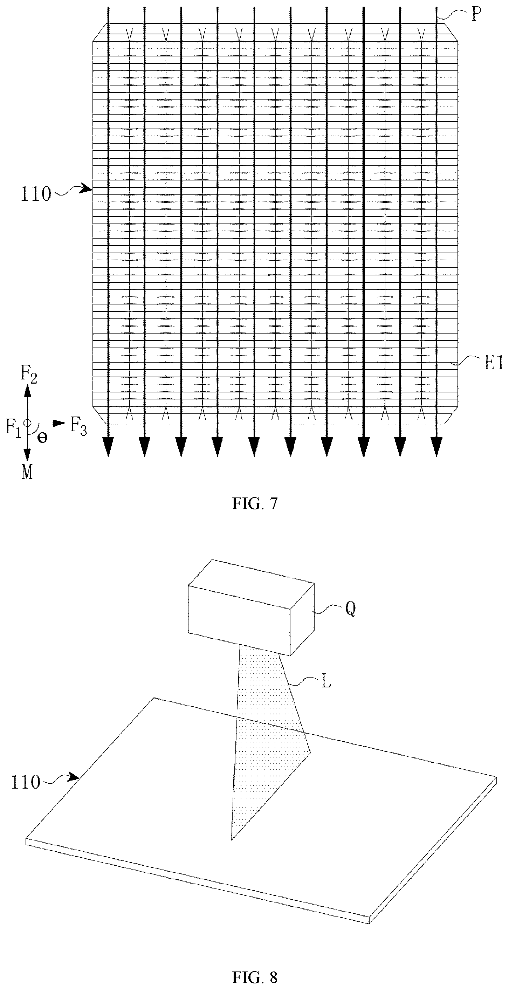

The laser may be emitted by a laser device, and the laser may be configured as a line laser. During the motion of the laser, an irradiation region formed by the linear beam may be substantially a line. Referring to FIG. 6, FIG. 6 is a schematic view showing a laser L irradiating on a solar cell substrate 110 according to some embodiments of the present application. Corresponding electrodes are not shown in FIG. 6. The laser L emitted by the laser device Q may be substantially a continuous linear beam. Referring to FIG. 7, FIG. 7 is a schematic view showing moving irradiation paths P according to some embodiments of the present application. Arrows in FIG. 7 show the moving irradiation paths P of the laser L, and the laser device Q may be controlled to move along the moving irradiation paths P. The number of the emitted lasers L may be determined according to specific usage requirements, i.e. the number of formed moving irradiation paths P shown in FIG. 7 is not specifically limited. Correspondingly, a plurality of laser devices Q may be arranged side by side to emit a plurality of side-by-side lasers L. Alternatively, one laser device Q may emit a plurality of lasers, which is not specifically limited herein. It may be understood that the denser the moving irradiation paths P are, the more regions on the solar cell substrate 110 are irradiated.

In some other embodiments, referring to FIG. 8, FIG. 8 is a schematic view showing the laser L irradiating on the solar cell substrate 110 according to some other embodiments of the present application. The emitted laser L forms a light spot with a certain length and in a linear shape approximately (which may be regarded as a strip-shaped light spot) on the solar cell substrate 110 and moves along an extension direction of the light spot. The formed irradiation region may also be regarded as a line. The laser may be selected according to specific usage requirements, which is not specifically limited herein.

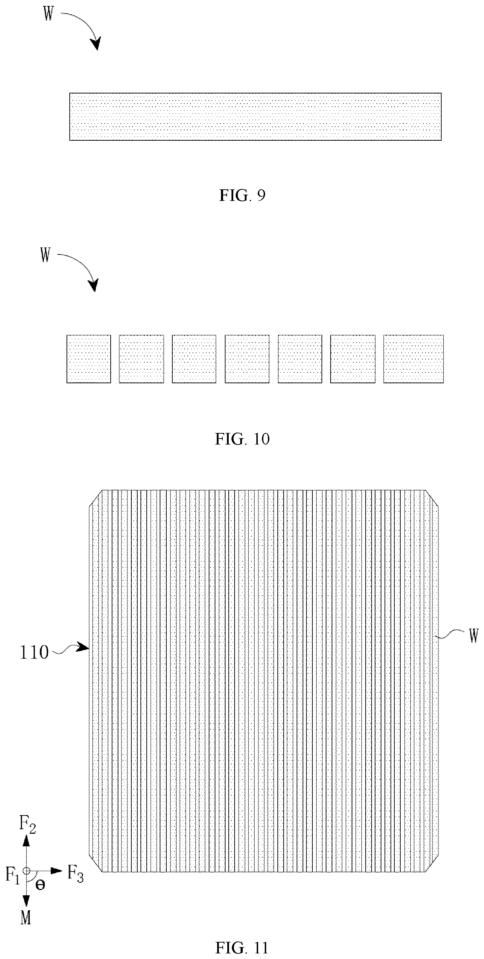

The laser performs a continuous moving irradiation, i.e., the laser moves along a direction to irradiate the solar cell substrate, and the motion of the laser irradiating the solar cell substrate can be regarded as continuous. One continuous moving irradiation process means that the laser moves in one direction once to irradiate the solar cell substrate. Since the laser light is emitted by the laser device, the continuous moving irradiation process can be regarded as controlling the laser to move in one direction to irradiate the solar cell substrate. In this process, the laser may emit light continuously or intermittently. In the case where the laser device emits light continuously, taking FIG. 9 as an example, the irradiation region W formed by the laser during the continuous moving irradiation process is continuous. In the case where the laser device emits light intermittently, taking FIG. 10 as an example, the irradiation region W formed by the laser during the continuous moving irradiation process is discontinuous, and the discontinuous irradiation region W may be regarded as an intermittent irradiation region W. The continuous moving irradiation process of the laser may be set according to the actual usage requirements, which is not specifically limited herein.

The irradiation region formed in the continuous moving irradiation process has a starting end and an ending end. The starting end and the ending end of the irradiation region can be set according to the usage requirements, and the desired irradiation region can be obtained by controlling an emission process and a movement process of the laser device. Referring to FIG. 11, FIG. 11 is a schematic view showing irradiation regions W on the solar cell substrate 100 according to some embodiments of the present application. For the convenience of showing the irradiation region W, the relevant electrodes are not shown. The starting end of the irradiation region W is one side edge of the solar cell substrate 110, and the ending end of the irradiation region W is another side edge of the solar cell substrate 110. In the case shown in FIG. 11, the irradiation region W is a continuous irradiation region. It can be understood that the width of each irradiation region W may be controlled by controlling a width of the light spot, and a distance between two adjacent irradiation regions W may be controlled by controlling a distance between the two corresponding lasers (i.e. a spacing between two adjacent light spots). Alternatively, in some other embodiments, the starting end and/or the ending end of the irradiation region W may not be corresponding edges of the solar cell substrate 110 and may be set according to the actual usage requirements, which is not specifically limited herein.

The number of times the continuous moving irradiation is performed is at least once, i.e., the number of times the continuous moving irradiation is performed may be once, twice or any other number of times. Among all continuous moving irradiation processes, there must be the target irradiation process, i.e., in the case where there is one continuous moving irradiation process, this continuous moving irradiation is the target irradiation process, and in the case where there are multiple continuous moving irradiation processes, at least one of the continuous moving irradiation processes is the target irradiation process. For the target irradiation process, taking FIG. 7 as an example, the longitudinal extension direction of the first electrode E1 is the third direction F₃ shown in FIG. 7, the thickness direction of the solar cell substrate 110 is the first direction F₁ shown in the figure, and the moving direction M of the laser light moving on the solar cell substrate 110 and the third direction F₃ intersect with each other, i.e., the moving direction M and the third direction F₃ are set to form a first angle *θ*. FIG. 7 shows that the moving direction M and the third direction F₃ are perpendicular to each other, and that the moving direction M and the second direction F₂ are parallel to each other, i.e., the first angle *θ* is 90°. Alternatively, the first angle *θ* may also be any other value, which is not specifically limited herein.

Thus, in the case illustrated above, after the first initial electrode is formed by the metallization heat treatment process, the laser-assisted sintering treatment is performed on the first initial electrode to form the first electrode and obtain the solar cell. In this process, through configuring the target irradiation process in the laser-assisted sintering treatment, the moving direction of the laser moving on the solar cell substrate in the target irradiation process and the longitudinal extension direction of the first electrode intersect with each other. Such that, on one hand, a portion of the irradiation region formed by the laser in the target irradiation process covers the electrode region of the solar cell, thereby improving the contact performance between the first electrode and the substrate, and on the other hand, another portion of the irradiation region formed by the laser in the target irradiation process covers the non-electrode region of the solar cell, thereby exciting carriers by means of the assistance of the non-electrode region. When a certain reverse bias voltage is applied, these excited charge carriers will move directionally to generate a local current. This local current may further cause the temperature of the sintered region to rise, thus promoting further mutual fusion and diffusion of the first initial electrode and the substrate, thereby further improving the contact performance between the formed first electrode and the substrate.

In related embodiments, conventionally, the moving direction of the laser is parallel to the longitudinal extension direction of the first electrode, and the laser acts on the first initial electrode or on a region adjacent to the first initial electrode to perform the laser-assisted sintering. However, in this manner, the laser-assisted sintering can only be performed on the electrode region, which limits the space for the contact performance improvement. Moreover, the first initial electrode or the region adjacent to the first initial electrode needs to be aligned, thus making it necessary to control the alignment accuracy of the laser, thus further causing it difficult to control the laser-assisted sintering treatment and causing the process efficiency to be too low.

It may be understood that, compared with the aforementioned related embodiments, the laser can not only form a larger range covering the non-electrode region in the target irradiation process, thereby exciting more carriers and significantly improving the contact performance between the formed first electrode and the substrate, but also reduce the requirement for controlling the alignment accuracy of the laser, thereby expanding a process window and improving the manufacturing efficiency as well.

Therefore, by configuring the target irradiation process above, not only can the contact performance between the first electrode and the substrate can be improved, thus improving the conversion efficiency of the solar cell, but also the solar cell is easy to processed and manufactured, and the manufacturing efficiency is improved.

In some embodiments, the number of times the laser is controlled to perform the continuous moving irradiation process on the solar cell substrate is multiple times. Where, the moving direction of the laser in the first continuous moving irradiation process and the longitudinal extension direction of the first electrode are parallel with each other. Alternatively, the first continuous moving irradiation process is the target irradiation process.

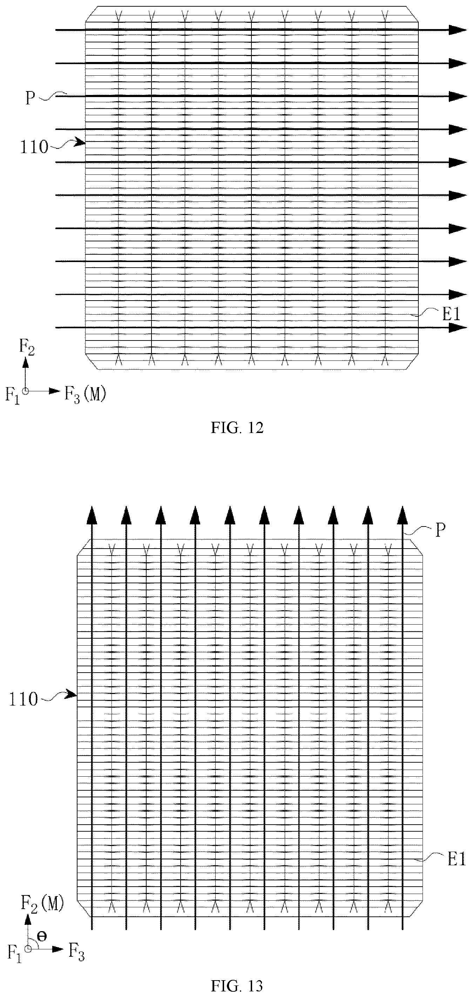

For the case where the first continuous moving irradiation process is not a target irradiation process, taking FIG. 12 as an example, the figure illustrates a case where the moving direction M of the laser and the longitudinal extension direction of the first electrode E1 are parallel with each other, i.e., the moving direction M and the third direction F₃ are parallel with each other. The extension direction of each moving irradiation path P shown in FIG. 12 and the extension direction of each moving irradiation path P shown in FIG. 7 are perpendicular to each other. In this case, the laser may perform a moving irradiation on the first initial electrode region on the solar cell substrate 110, and the first initial electrode region includes a region where the first initial electrode is located or a region adjacent to the first initial electrode. In this way, a preliminary laser-assisted sintering treatment (which can be regarded as a pre-assisted sintering process) may be performed on the first initial electrode by means of the first continuous moving irradiation process, and then the laser-assisted sintering treatment is further performed on the first initial electrode by means of a following target irradiation process.

In other embodiments, the first continuous moving irradiation process may also be the moving irradiation performed by the laser on the non-first initial electrode region of the solar cell substrate, to promote the generation of carriers, thereby initially promoting further mutual fusion and diffusion between the first initial electrode and the substrate.

In the case where the first continuous moving irradiation process is the target irradiation process, firstly, the assisted sintering process is performed on the first initial electrode and the non-first initial electrode region by means of the target irradiation process, and at the same time, a preliminary treatment is performed on the first initial electrode and the non-first initial electrode region, and then the required laser-assisted sintering treatment is completed by controlling a subsequent continuous moving irradiation process.

In the first continuous moving irradiation process illuminated above, by combining different preliminary treatment processes, different contact forms between the first initial electrode and the substrate may be obtained. According to the different contact forms, different subsequent continuous moving irradiation processes may be configured purposely, thereby realizing different processes and different contact performances to meet different usage requirements.

Exemplarily, in the case where the number of times the continuous moving irradiation is performed is twice, the first continuous moving irradiation process may be as illustrated in FIG. 12, and the last continuous moving irradiation process is the target irradiation process. The reverse bias voltage of the laser used in the last continuous moving irradiation process is less than the reverse bias voltage of the laser used in the first continuous moving irradiation process, and the power of the laser used in the last continuous moving irradiation process is less than the power of the laser used in the first continuous moving irradiation process. The first continuous moving irradiation process enables the first initial electrode to come in preliminary contact with the doped layer without generating metal composite, and the last continuous moving irradiation process enables the first initial electrode to come in ohmic contact with the doped layer and promotes the generation of carriers in the non-electrode region, thereby contributing to further mutual fusion and diffusion of the first initial electrode and the doped layer, and improving the contact performance.

In this way, the subsequent continuous moving irradiation process can be flexibly configured according to the specific process of the first continuous moving irradiation process. By controlling relevant parameters of the laser in the different continuous moving irradiation processes, the window of a process control is enlarged, and the degree of controllability is higher, thus not only can the desired solar cell be obtained according to the usage demand, but also the manufacture is further facilitated.

In some embodiments, the number of times the laser is controlled to perform the continuous moving irradiation on the solar cell substrate is at least three times. Continuous moving irradiation processes other than the first continuous moving irradiation process are all target irradiation processes. The moving directions of the laser moving on the solar cell substrate in all target irradiation processes constitute a moving direction set. Where, in the moving direction set, there are a plurality of moving directions being the same, or a plurality of moving directions being opposite. Alternatively, in the moving direction set, there are a plurality of moving directions intersecting with each other.

The moving direction set is specifically configured for the target irradiation process, and the moving direction set refers to a set including the plurality of moving directions. Each target irradiation process corresponds to a moving direction, and the number of target irradiation processes is the same as the number of moving directions in the moving direction set.

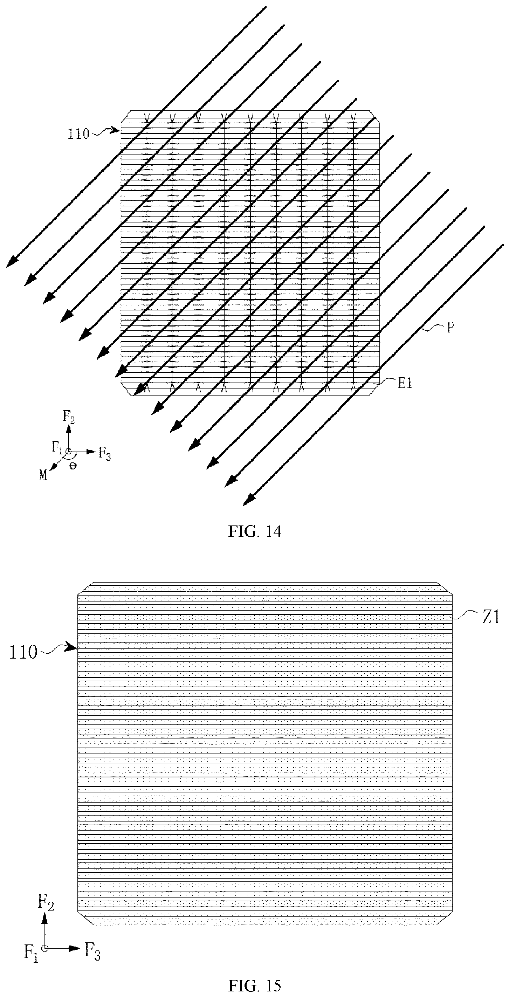

Taking a plurality of moving directions being the same in the moving direction set as an example, there are a plurality of target irradiation processes in which the moving directions of the laser are the same, that is, the moving directions of the laser in the plurality of target irradiation processes are the same. Taking a plurality of moving directions being opposite in the moving direction set as an example, there are a plurality of target irradiation processes in which the moving directions of the laser are opposite, that is, the moving directions of the laser in the plurality of target irradiation processes are opposite, and for the plurality of target irradiation processes being neighboring target irradiation processes, the laser device may be regarded as substantially moving back and forth in corresponding directions. In the moving direction set, there may be a plurality of moving directions being the same and a plurality of moving directions being opposite as well. For example, referring to FIG. 13, FIG. 13 is a schematic view showing moving irradiation paths P according to some other embodiments of the present application, and the moving direction M shown in FIG. 7 is opposite to the moving direction M shown in FIG. 13. As another example, referring to FIG. 14, FIG. 14 is a schematic view showing moving irradiation paths P according to yet some other embodiments of the present application, and the moving direction M shown in FIG. 7 and the moving direction M shown in FIG. 14 intersect with each other.

In this way, the case where the plurality of moving directions are the same or the plurality of moving directions are opposite is beneficial to controlling the moving process of the laser device. Further, in the case where two neighboring target irradiation processes correspond to opposite moving directions, the sintering efficiency can be further improved. The case where there are a plurality of moving directions intersecting with each other is beneficial to irradiating the solar cell substrate more completely, thereby further improving the contact performance.

In some embodiments, the reverse bias voltage of the laser in the first continuous moving irradiation process is greater than that of the laser in any one of the continuous moving irradiation processes other than the first continuous moving irradiation process.

The larger reverse bias voltage can enhance the transport ability of the carriers, thus helping the first initial electrode and the dopant layer to diffuse into each other to come in good ohmic contact, therefore, the electric field strength can be enhanced in the first continuous moving irradiation process to excite an accelerated motion of the carriers between the first initial electrode and the solar cell substrate, which not only helps to break a potential barrier at the interface more effectively, thus promoting a mutual diffusion of metal atoms and silicon atoms and forming a better ohmic contact, but also helps to promote nucleation and growth of the metal grains, thus forming larger-sized grains and improving the electrical conductivity of the electrode. By combining with the relatively low reverse bias voltage in the subsequent continuous moving irradiation processes, not only can the initially formed ohmic contact be precisely adjusted, but also the flatness and stability of the contact interface can be further optimized, and the growth of the metal grains can be controlled to reduce the surface roughness and unevenness of the first electrode caused by the oversized metal grains. In this way, by setting different reverse bias voltages, flexible adjustments can be made according to different manufacturing stages and material properties of the solar cell.

It may be understood that, for the first initial electrodes of different types and thicknesses, the reverse bias voltage of the laser can be flexibly adjusted as required. For example, for some metal electrode materials with higher melting points, a higher initial reverse bias voltage may be applied to promote sintering. For another example, for a relatively fragile substrate, a subsequent relatively low reverse bias voltage can reduce damage to the substrate. In this way, process flexibility and adaptability may be improved.

The first initial electrode and the dopant layer form a certain metal composite, and by combining with the lowered reverse bias voltage in the subsequent continuous moving irradiation process, the contact between the first initial electrode and the dopant layer can be further controlled more accurately to form the desired first electrode, thereby helping to control and enhance the contact performance of the first electrode.

In some embodiments, the power of the laser in the first continuous moving irradiation process is greater than that of the laser in any one of the continuous moving irradiation processes other than the first continuous moving irradiation process.

Since the greater laser power can provide a higher energy input in a shorter period of time to accelerate the curing of the first initial electrode and promote the mutual fusion and diffusion of the first initial electrode and the dopant layer, the first continuous moving irradiation process enables the first initial electrode and the dopant layer to form a certain metal composite, and the organic and volatile substances in the first initial electrode can be removed more rapidly, thereby solving the problem that bubbles and defects are generated in the subsequent continuous moving irradiation process. By combining with the relatively low laser power in the subsequent continuous moving irradiation process, the growth of the grains of the first initial electrode can be controlled to make the grains more uniform and smaller, thereby further optimizing the contact interface, reducing the interfacial defects and composite centers, improving the electrical conductivity and stability of the formed first electrode. In this way, the first initial electrode can be more precisely adjusted and optimized.

It may be understood that for the first initial electrode of different types and thicknesses, the power of the laser can be flexibly adjusted as needed. For example, for a relatively thick first initial electrode, the power of the laser may be relatively high in the first continuous moving irradiation process to improve the adequacy of sintering. For example, for a temperature-sensitive first initial electrode, the laser power can be lowered in the subsequent continuous moving irradiation process to solve an overheating damage. In this way, the process window as well as the adaptability of the process can be expanded.

In some embodiments, the laser used in any one of the continuous moving irradiation processes other than the first continuous moving irradiation process is configured as a red laser. Exemplarily, the laser used in the first continuous moving irradiation process may be a green laser, a UV laser, or other lasers, and these lasers not only have relatively high energy, but also are readily available and less expensive.

Since the red laser, compared with some high-energy lasers, has a relatively low energy, the usage of the red laser in the subsequent continuous moving irradiation process may improve the situation of causing excessive damages to the formed structure or causing damages to the solar cell substrate.

The above-illustrated embodiments of controlling the reverse bias voltage of the laser and the power of the laser, as well as the embodiments of configuring the type of the laser, can be all adopted together, thereby improving the performance of the manufactured solar cell through the mutual coordination of all continuous moving irradiation processes.

In some embodiments, the irradiation region formed by each continuous moving irradiation process is the same region.

In this way, it is not only convenient to control the continuous moving irradiation process of the laser, but also beneficial to configuring the desired continuous moving irradiation process according to the region, thereby manufacturing the desired first electrode.

In some embodiments, among the irradiation regions formed by all the continuous moving irradiation processes, there are some different irradiation regions.

In this way, different continuous moving irradiation processes can be configured according to different states of the regions in the process of manufacturing the first electrode, which is beneficial to further improving the performance of the solar cell as a whole.

FIG. 15 is a schematic view showing a first target region Z1 on the solar cell substrate 110 according to some embodiments of the present application. For ease of description, only contents related to the embodiments of the present application are shown. For ease of illustrating the first target region Z1, related electrodes are not shown.

In some embodiments, referring to FIG. 15, there is the first target region Z1 among all irradiation regions. The first target region Z1 is determined based on the position of the first initial electrode. That is, the first target region Z1 at least includes a portion of the region where the first initial electrode is located.

Specifically, the first target region Z1 may be formed when the first continuous moving irradiation process described above is the non-target irradiation process. For example, taking FIG. 15 as an example, the figure shows a case where the first target region Z1 includes the region where the first initial electrode is located and a region near the region where the first initial electrode is located. The first target region Z1 and the first initial electrode are substantially in a one-to-one correspondence. In this case, the first target region Z1 includes all regions where the first initial electrodes are located.

In this way, the first target region is determined based on the position where the first initial electrode is located, so that the laser-assisted sintering can be performed on the first initial electrode more purposely, which is beneficial to improving the contact performance between the formed first electrode and the doped layer.

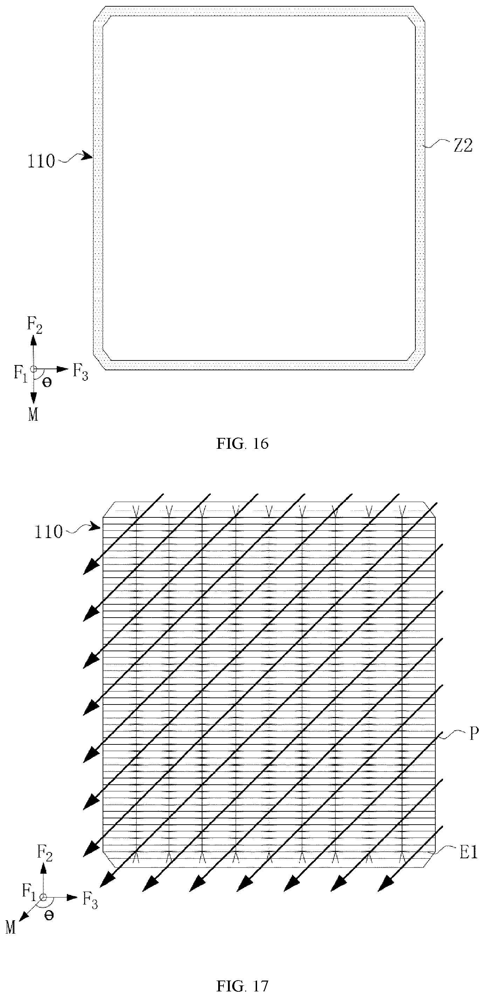

FIG. 16 is a schematic view showing a relationship between the solar cell substrate 110 and a second target region Z2 according to some embodiments of the present application. For ease of description, only the contents related to the embodiments of the present application are shown. For ease of illustrating the second target region, the related electrodes are not shown.

In some embodiments, referring to FIG. 16, there is a second target region Z2 among all of the irradiation regions. The second target region Z2 is determined based on a corresponding region on a side surface of the solar cell substrate 110 where the first initial electrode e1 is located. The corresponding region includes at least one of a poorly sintered region of the first initial electrode and an edge region of the solar cell substrate. Taking FIG. 16 as an example, this figure illustrates the case where the second target region Z2 is the edge region of the solar cell substrate 110.

In the process of forming the first electrode, there may be a case where a certain region of the first initial electrode is poorly sintered. In this case, the second target region can be configured based on the poorly sintered region of the first initial electrode, and then the laser-assisted sintering can be performed on the defective region of the first initial electrode purposely, thereby improving a sintering yield of the first initial electrode.

When the screen printing is performed to print the first initial electrode, it is easy to cause too much paste printed on the edge region of the solar cell substrate, which makes the sintering effect of the edge region different from that of the middle region, thus making it difficult to control the sintering process. In this case, the second target region may be configured based on the edge region of the solar cell substrate, and then the laser-assisted sintering can be performed purposely on the region where sintering effect is difficult to control, thereby improving the sintering effect of the edge region of the solar cell substrate.

In some embodiments, the order of all irradiation regions, which are formed by all of the continuous moving irradiation processes performed in an order, is preset. The sorting number corresponding to the second target region is an intermediate number. Alternatively, the sorting number corresponding to the second target region is the first number. Alternatively, the sorting number corresponding to the second target region is the last number.

That is, the sorting number of the irradiation region formed by the first continuous moving irradiation process is the first, the sorting number of the irradiation region formed by the second continuous moving irradiation process is the second, and so on. In the case where the sorting number corresponding to the second target region is an intermediate number, the number of the continuous moving irradiation processes is at least three, and the irradiation region formed by any continuous moving irradiation process, other than the first continuous moving irradiation process and the last continuous moving irradiation process, includes the second target region. In the case where the sorting number corresponding to the second target region is the first, the irradiation region formed by the first continuous moving irradiation process includes the second target region. In the case where the sorting number corresponding to the second target region is the last number, the irradiation region formed by the last continuous moving irradiation process includes the second target region.

For example, after the first initial electrode is formed by the metallization heat treatment process, the second target region can be determined according to a detection result, and the sintering effect of the second target region is improved by the first continuous moving irradiation process. For another example, after any one of the continuous moving irradiation processes, the second target region can be determined according to a detection result, and then a continuous moving irradiation process is performed to improve the sintering effect of the second target region. For another example, after all the continuous moving irradiation processes are performed, the second target region can be determined according to a detection result, and then the laser-assisted sintering is performed to improve the sintering effect of the second target region. The sintering effect of the second target region can be improved according to a situation of a specific usage or according to specifically configured processes, which is not specifically limited herein.

In some embodiments, continuing to refer to FIG. 7, FIG. 13 and FIG. 14, in the target irradiation process, the angle formed by the moving direction M of the laser and the longitudinal extension direction of the first electrode E1 is in a range from 45° to 135°. That is, the angle formed by the moving direction M of the laser during the target irradiation process and the longitudinal extension direction of the first electrode E1 is the first angle *θ*, and the first angle *θ* is within the range from 45° to 135°.

Exemplarily, the first angle *θ* may be 45°, 55°, 65°, 80°, 90°, 100°, 110°, 120° or 135°. Taking FIG. 7 and FIG. 13 as examples, the case where the first angle *θ* is 90° is illustrated. Taking FIG. 14 as an example, the case where the first angle *θ* is 135° is illustrated. It may be understood that the first angle *θ* formed by a moving direction opposite to the moving direction M shown in FIG. 14 and the longitudinal extension direction of the first electrode E1 is 45°. In an actual implementation process, the first angle *θ* may be any angle within the range.

It may be understood that, in two continuous moving irradiation processes corresponding to the respective situations illustrated in FIGS. 7 and 13, the moving directions M of the laser in the two continuous moving irradiation processes are opposite, that is, it may be understood that there are a plurality of opposite moving directions in the moving direction set described in some embodiments above.

In this way, a desired first angle can be flexibly set according to an actual usage. When the first angle *θ* is in the range from 45° to 135°, the processing effect can be improved in combination with the shape of the solar cell substrate while performing the laser-assisted sintering.

In some embodiments, the reverse bias voltage of the laser is in a range from 10V to 30V, the power of the laser is in a range from 10W to 100W, and the scanning speed of the laser is in a range from 20000 mm/s to 200000 mm/s.

Exemplarily, the reverse bias voltage of the laser may be 10V, 12V, 15V, 16V, 17V, 19V, 21V, 25V, or 30V, the power of the laser can be 10W, 13W, 16W, 18W, 20W, 25W, 30W, 40W, 50W, 70W, 80W, 90W, or 100W, and the scanning speed of the laser may be 20000 mm/s, 30000 mm/s, 50000 mm/s, 80000 mm/s, 110000 mm/s, 150000 mm/s, 180000 mm/s, or 200000 mm/s. In an actual implementation process, the reverse bias voltage of the laser, the power of the laser, and the scanning speed of the laser may be any value within their respective ranges.

In this way, controlling the reverse bias voltage of the laser is not only beneficial to reducing the recombination probability of carriers, but also beneficial to reducing the risk of damaging the solar cell substrate. Controlling the power of the laser is not only beneficial to the short-term temperature rise inside the first initial electrode, but also beneficial to reducing the risk of overburning the first initial electrode, thereby reducing the risk of damaging the solar cell substrate. Controlling the scanning speed of the laser can reduce the risk of damaging the solar cell substrate due to excessive thermal effects while maintaining a certain efficiency. In this way, the reverse bias voltage of the laser, the power of the laser and the scanning speed of the laser can be flexibly set in different continuous moving irradiation processes, and the usage requirements of different continuous moving irradiation processes can be met through the mutual coordination of the three.

In some embodiments, continuing to refer to FIG. 9 and FIG. 10, an irradiation region W formed by each of the continuous moving irradiation processes is continuously extended or discontinuously extended.

Specifically, multiple lasers are configured in the continuous moving irradiation process, and each laser performs a moving irradiation on the solar cell substrate to form an irradiation region, and the irradiation region formed in the same continuous moving irradiation process is composed of the irradiation regions formed by the moving irradiations performed by all lasers.

It should be noted that multiple light emitting devices may be integrated in the same laser device to emit lasers. Alternatively, multiple laser devices may be provided to emit lasers separately. The multiple lasers may be arranged side by side, or they may be arranged according to a desired light emitting pattern, which is not specifically limited herein. For the convenience of describing the corresponding continuous moving irradiation process, above-illustrated FIGS. 7, 12 to 14 are only illustrated for one continuous moving irradiation process, and for the ease of understanding, the first electrode E1 is shown, and the FIG. 17 illustrated later can also be understood in the same way. In the same continuous moving irradiation process, all lasers may be emitted at the same time or at different times. Regardless of whether the lasers are emitted at the same time or at different times, the emission of the corresponding lasers can be controlled according to the desired irradiation region. For example, when the same irradiation region is extended intermittently, the laser corresponding to the irradiation region can be emitted intermittently. For different continuous moving irradiation processes, the corresponding laser emission can be configured according to the patterns formed by the desired irradiation regions in different processes and according to different moving irradiation sequences. The patterns constituted by the desired irradiation regions in different processes may be pre-set in a control program or may be set according to the detection results as mentioned in some of the above embodiments, which is not specifically limited herein. It may be understood that the first target region and the second target region described above may also be set in this way.

Exemplarily, taking FIG. 14 and FIG. 17 as examples, FIG. 17 is a schematic view showing moving irradiation paths P according to some embodiments of the present application, and the moving direction M shown in FIG. 14 and the moving direction M shown in FIG. 17 are the same. In the situation shown in FIG. 14, multiple lasers may be emitted simultaneously. Compared with FIG. 14, in the situation shown in FIG. 17, the lasers may be emitted according to the preset pattern mentioned above. In this case, it can be roughly regarded as emitting the lasers based on the edge defined by the outline of the solar cell substrate. According to different moving irradiation sequences and moving irradiation processes, the preset pattern may also be any other pattern, which is not specifically limited herein.

In this way, by extending the irradiation region continuously or intermittently, not only can the requirements for different continuous moving irradiation processes be flexibly met, but also the laser cost can be saved, and the work efficiency can be improved.

In some embodiments, the number of times the laser is controlled to perform the continuous moving irradiation on the solar cell substrate is twice.

In this way, the sintering effect can be improved while reducing the cost of usage and improving the work efficiency.

Of course, in some other embodiments, the number of times the laser is controlled to perform the continuous moving irradiation on the solar cell substrate may be three times, four times, etc., which is not specifically limited herein.

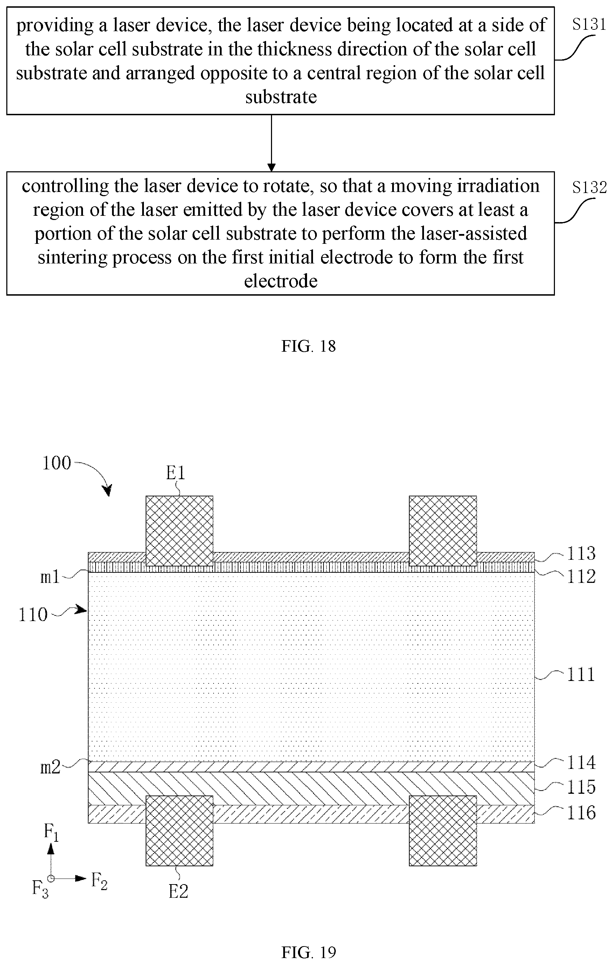

FIG. 18 is a flow chart showing step S130 of the method for manufacturing solar cell according to some embodiments of the present application. For ease of description, only the contents related to the embodiments of the present application are shown.

In some embodiments, referring to FIG. 18, step S130 includes the following steps:

Step S131, providing a laser device, where the laser device is located at a side of the solar cell substrate in the thickness direction thereof and is arranged opposite to the central region of the solar cell substrate; and

Step S132, controlling the laser device to rotate, so that the moving irradiation region of the laser emitted by the laser device can cover at least a portion of the solar cell substrate, and that the laser-assisted sintering treatment is performed on the first initial electrode to form the first electrode.

Exemplarily, referring to FIG. 6 and FIG. 8, the laser device Q is located over the solar cell substrate 110 and arranged to be directly opposite to the center of the solar cell substrate 110.

In this way, the laser is controlled in a manner of rotation, so that errors of the irradiation region formed in the continuous moving irradiation process can be reduced, thereby helping to improve the accuracy of the laser-assisted sintering and improve the sintering effect.

In combination with the above-mentioned embodiments and related comparative examples, the solar cell manufactured by the method for manufacturing solar cell provided in the embodiments of the present application is exemplarily described hereinafter.

Taking a structure of a solar cell 100 shown in FIG. 19 as an example, the solar cell 100 includes a solar cell substrate 110, a first electrode E1 and a second electrode E2. The solar cell substrate 110 includes a base 111, a doped layer 112, a first passivation layer 113, a tunneling layer 114, a doped conductive layer 115 and a second passivation layer 116. The doped layer 112, the first passivation layer 113 and the first electrode E1 are sequentially arranged on the first surface m1 of the base 111. The first electrode E1 and the doped layer 112 are in ohmic contact. The tunneling layer 114, the doped conductive layer 115, the second passivation layer 116 and the second electrode E2 are sequentially arranged on the second surface m2 of the base 111. The second electrode E2 and the doped conductive layer 115 are in ohmic contact. The base 111 is an N-type base with a thickness of 0.15 nm. The doped layer 112 is made of boron-doped single crystal silicon with a thickness of 1000 nm. The first passivation layer 113 is made of SixOyNz with a thickness of 80 nm. The tunneling layer 114 is made of SixOy with a thickness of 1.2 nm. The doped conductive layer 115 is made of phosphorus-doped polycrystalline silicon with a thickness of 100 nm. The second passivation layer 116 is made of SixNy with a thickness of 100 nm. The first electrode E1 is made of Ag with a width of 20 µm, and the number of first electrodes is 150. The second electrode E2 is made of Ag with a width of 40 µm, and the number of the second electrodes is 200.

In Example 1, after the first initial electrode is formed by the metallization heat treatment process, the laser is controlled to perform the continuous moving irradiation on the solar cell substrate 110 twice. The moving direction M of the laser in the first continuous moving irradiation process is set at 90° to the longitudinal extension direction of the first electrode E1, the reverse bias voltage of the laser is 10V, the power of the laser is 100W, and the scanning speed of the laser is 20000 mm/s. The moving direction M of the laser in the second continuous moving irradiation process is set at 90° to the longitudinal extension direction of the first electrode E1, the reverse bias voltage of the laser is 30V, the power of the laser is 10W, and the scanning speed of the laser is 200000 mm/s.

In Example 2, after the first initial electrode is formed by the metallization heat treatment process, the laser is controlled to perform the continuous moving irradiation on the solar cell substrate 110 twice. The moving direction M of the laser in the first continuous moving irradiation process is set at 45° to the longitudinal extension direction of the first electrode E1, the reverse bias voltage of the laser is 15V, the power of the laser is 50W, and the scanning speed of the laser is 100000 mm/s. The moving direction M of the laser in the second continuous moving irradiation process is set at 45° to the longitudinal extension direction of the first electrode E1, the reverse bias voltage of the laser is 15V, the power of the laser is 50W, and the scanning speed of the laser is 100000 mm/s.

In Example 3, after the first initial electrode is formed by the metallization heat treatment process, the laser is controlled to perform the continuous moving irradiation on the solar cell substrate 110 twice. The moving direction of the laser in the first continuous moving irradiation process is set at 90° to the longitudinal extension direction of the first electrode, the reverse bias voltage of the laser is 30V, the power of the laser is 10W, and the scanning speed of the laser is 200000 mm/s. The moving direction of the laser in the second continuous moving irradiation process is set at 45° to the longitudinal extension direction of the first electrode, the reverse bias voltage of the laser is 15V, the power of the laser is 10W, and the scanning speed of the laser is 50000 mm/s.

In Example 4, after the first initial electrode is formed by the metallization heat treatment process, the laser is controlled to perform the continuous moving irradiation on the solar cell substrate 110 once. The moving direction M of the laser during the continuous moving irradiation is set at 90° to the longitudinal extension direction of the first electrode E1, the reverse bias voltage of the laser is 15V, the power of the laser is 15W, and the scanning speed of the laser is 50000 mm/s.

In Example 5, after the first initial electrode is formed by the metallization heat treatment process, the laser is controlled to perform the continuous moving irradiation on the solar cell substrate 110 twice. The moving direction M of the laser in the first continuous moving irradiation process is parallel to the longitudinal extension direction of the first electrode E1, the reverse bias voltage of the laser is 15V, the power of the laser is 15W, and the scanning speed of the laser is 100000 mm/s. The moving direction M of the laser in the second continuous moving irradiation process is set at 90° to the longitudinal extension direction of the first electrode E1, the reverse bias voltage of the laser is 15V, the power of the laser is 15W, and the scanning speed of the laser is 100000 mm/s.

In comparative example 1, after the first initial electrode is formed by the metallization heat treatment process, the laser is controlled to perform the continuous moving irradiation on the solar cell substrate 110 once. The moving direction M of the laser in the continuous moving irradiation process is parallel to the longitudinal extension direction of the first electrode E1, the reverse bias voltage of the laser is 15V, the power of the laser is 15W, and the scanning speed of the laser is 100000 mm/s. The irradiation region formed by the continuous moving irradiation process is set based on the first initial electrode region.

In comparative example 2, after the first initial electrode is formed by the metallization heat treatment process, the laser is controlled to perform the continuous moving irradiation on the solar cell substrate 110 twice. The moving direction M of the laser in the first continuous moving irradiation process is parallel to the longitudinal extension direction of the first electrode E1, the reverse bias voltage of the laser is 15V, the power of the laser is 15W, and the scanning speed of the laser is 100000 mm/s. The moving direction M of the laser in the second continuous moving irradiation process is parallel to the longitudinal extension direction of the first electrode E1, the reverse bias voltage of the laser is 15V, the power of the laser is 15W, and the scanning speed of the laser is 100000 mm/s. The irradiation region formed by the two continuous moving irradiation processes is set based on the first initial electrode region.

Powers of the solar cells manufactured in the above-mentioned examples and comparative examples were tested under the circumstance of AM1.5G simulated sunlight at 25 degrees Celsius by using a source measure unit. The test results are shown in Table 1.

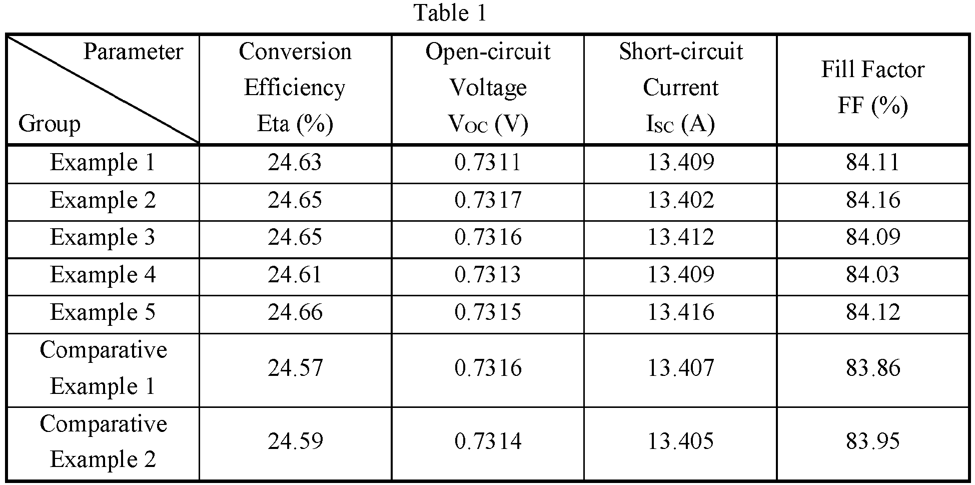

As can be seen from Table 1, compared with the comparative Example 1, in Example 4, the laser also irradiated once, but the moving direction M of the laser was perpendicular to the longitudinal extension direction of the first electrode E1, and the conversion efficiency of the solar cell in Example 4 was increased by 0.04 %. Compared with the comparative Example 1, in each of Example 1, Example 2, Example 3 and Example 5, the laser irradiated twice, and at least once the moving direction M of the laser was not parallel to the longitudinal extension direction of the first electrode E1, so that the conversion efficiency of the solar cell was increased by more than 0.06%. Compared with the comparative Example 2, in each of Example 1, Example 2, Example 3 and Example 5, the laser irradiated twice, and at least once the moving direction M of the laser was not parallel to the longitudinal extension direction of the first electrode E1, so that the conversion efficiency of the solar cell is increased by more than 0.04%. Compared with the comparative Example 2, in Example 4, the laser only irradiated once, and the conversion efficiency of the solar cell in Example 4 was increased by 0.02%. It can be seen that the conversion efficiencies of the solar cells provided in the examples of the present application are improved.

Based on the same inventive concept, an embodiment of the present application provides a solar cell, which is manufactured by the method for manufacturing solar cell in any of the above embodiments.

It should be noted that the solar cell may be a TOPCon cell, a BC cell or a cell of any other type, which are not specifically limited herein. The solar cell may be provided with a main grid electrode or not, which is not specifically limited herein. In FIGS. 7, 12-14 and 17, the main grid electrodes are shown (but not indicated).

The solar cell also has the advantages of the above-mentioned method for manufacturing solar cell, which will not be described repeatedly hereinafter.

The above-described embodiments may be arbitrarily combined. To make the description concise, not all possible combinations of the technical features in the above-described embodiments are described. However, as long as there is no contradiction in the combinations of these technical features, the combinations should be considered to be within the scope of this specification.

The embodiments above only represent several implementation modes of the present application, and the description thereof is relatively specific and detailed, but it should not be construed as limiting the scope of the patent. It should be noted that for those ordinary skilled in the art, various modifications and improvements may be made without departing from the scope of the appended claims.

## Claims

1. A method for manufacturing solar cell (100), **characterized by** comprising:
providing a solar cell substrate (110);
forming, by a metallization heat treatment process, a first initial electrode (e1) on the solar cell substrate (110); and
controlling a laser (L) to perform a continuous moving irradiation on the solar cell substrate (110), and performing a laser-assisted sintering treatment on the first initial electrode (e1) to form a first electrode (E1) and obtain the solar cell (100);
wherein the number of times the laser (L) is controlled to perform the continuous moving irradiation on the solar cell substrate (110) is multiple times;
the moving direction (M) of the laser (L) in a first continuous moving irradiation process and the longitudinal extension direction (F3) of the first electrode (E1) are parallel with each other; and
there is a target irradiation process among all continuous moving irradiation processes, and in the target irradiation process, a moving direction (M) of the laser (L) moving on the solar cell substrate (110) and a longitudinal extension direction (F₃) of the first electrode (E1) intersect with each other, and the moving direction (M) of the laser (L) moving on the solar cell substrate (110) and the longitudinal extension direction (F₃) of the first electrode (E1) are perpendicular to a thickness direction (F₁) of the solar cell substrate (110).

2. The method for manufacturing solar cell according to claim 1, wherein the number of times the laser (L) is controlled to perform the continuous moving irradiation on the solar cell substrate (110) is at least three times; the continuous moving irradiation processes other than the first continuous moving irradiation process are all target irradiation processes; in all target irradiation processes, moving directions (M) of lasers (L) moving on the solar cell substrate (110) constitute a moving direction set;
wherein in the moving direction set, there are a plurality of moving directions being the same or a plurality of moving directions being opposite; or in the moving direction set, there are a plurality of moving directions intersecting with each other.

3. The method for manufacturing solar cell according to claim 1, wherein the laser (L) used in any one of the continuous moving irradiation processes other than the first continuous moving irradiation process is configured as a red laser.

4. The method for manufacturing solar cell according to claim 1, wherein an irradiation region (W) formed in each of the continuous moving irradiation processes is the same region.

5. The method for manufacturing solar cell according to claim 1, wherein there are a plurality of different irradiation regions among irradiation regions (W) formed by all of the continuous moving irradiation processes.

6. The method for manufacturing solar cell according to claim 5, wherein there is a first target region (Z1) among all of the irradiation regions (W); and
the first target region (Z1) is determined based on a position of the first initial electrode (e1).

7. The method for manufacturing solar cell according to claim 5, wherein there is a second target region (Z2) among all of the irradiation regions (W);
the second target region (Z2) is determined based on a corresponding region on a side surface of the solar cell substrate (110) where the first initial electrode (e1) is located, and the corresponding region comprises at least one of a poorly sintered region of the first initial electrode (e1) and an edge region of the solar cell substrate (110).

8. The method for manufacturing solar cell according to any one of claims 1 to 7, wherein an irradiation region (W) formed by each of the continuous moving irradiation processes is continuously extended or discontinuously extended.

9. The method for manufacturing solar cell according to claim 1, wherein the number of times the laser (L) is controlled to perform the continuous moving irradiation on the solar cell substrate (110) is twice.

10. The method for manufacturing solar cell according to any one of claims 1 to 9, wherein the solar cell substrate (110) comprises a base (111), a doped layer (112), a first passivation layer (113), a tunneling layer (114), a doped conductive layer (115) and a second passivation layer (116);
wherein the base (111) has dopant elements therein; the base (111) has a first surface (m1) and a second surface (m2); the doped layer (112) and the first passivation layer (113) are arranged on the first surface (m1) of the base (111) in sequence; and the tunnelling layer (114), the doped conductive layer (115) and the second passivation layer (116) are arranged on the second surface (m2) of the base (111) in sequence.

11. The method for manufacturing solar cell (100) according to any one of claims 1 to 10, wherein controlling the laser (L) to perform the continuous moving irradiation on the solar cell substrate (110), and performing the laser-assisted sintering treatment on the first initial electrode (e1) to form the first electrode (E1) and obtain the solar cell (100), comprising:
providing a laser device (Q), the laser device (Q) being located at a side of the solar cell substrate (110) in the thickness direction (F₁) of the solar cell substrate (110) and arranged opposite to a central region of the solar cell substrate (110); and
controlling the laser device (Q) to rotate, so that a moving irradiation region of the laser (L) emitted by the laser device (Q) covers at least a portion of the solar cell substrate (110) to perform the laser-assisted sintering treatment on the first initial electrode (e1) to form the first electrode (E1).

## Patentansprüche

1. Verfahren zur Herstellung einer Solarzelle (100), **gekennzeichnet dadurch, dass** das Verfahren Folgendes umfasst:
Bereitstellen eines Solarzellensubstrats (110);
Ausbilden, durch einen Metallisierungswärmebehandlungsvorgang, einer ersten anfänglichen Elektrode (e1) auf dem Solarzellensubstrat (110); und
Steuern eines Lasers (L), um eine kontinuierliche sich bewegende Bestrahlung auf dem Solarzellensubstrat (110) durchzuführen, und Durchführen einer lasergestützten Sinterbehandlung an der ersten anfänglichen Elektrode (e1), um eine erste Elektrode (E1) auszubilden und die Solarzelle (100) zu erhalten;
wobei die Anzahl der Male, die der Laser (L) gesteuert wird, um die kontinuierliche sich bewegende Bestrahlung auf dem Solarzellensubstrat (110) durchzuführen, mehrere Male beträgt;
die Bewegungsrichtung (M) des Lasers (L) bei einem ersten kontinuierlichen sich bewegenden Bestrahlungsvorgang und die Längserstreckungsrichtung (F3) der ersten Elektrode (E1) parallel zueinander verlaufen; und
es einen Zielbestrahlungsvorgang unter allen kontinuierlichen sich bewegenden Bestrahlungsvorgängen gibt und sich bei dem Zielbestrahlungsvorgang eine Bewegungsrichtung (M) des Lasers (L), der sich auf dem Solarzellensubstrat (110) bewegt, und eine Längserstreckungsrichtung (F₃) der ersten Elektrode (E1) miteinander schneiden und die Bewegungsrichtung (M) des Lasers (L), der sich auf dem Solarzellensubstrat (110) bewegt, und die Längserstreckungsrichtung (F₃) der ersten Elektrode (E1) senkrecht zu einer Dickenrichtung (F₁) des Solarzellensubstrats (110) verlaufen.

2. Verfahren zur Herstellung einer Solarzelle nach Anspruch 1, wobei die Anzahl der Male, die der Laser (L) gesteuert wird, um die kontinuierliche sich bewegende Bestrahlung auf dem Solarzellensubstrat (110) durchzuführen, mindestens drei Male beträgt; die kontinuierlichen sich bewegenden Bestrahlungsvorgänge mit Ausnahme des ersten kontinuierlichen sich bewegenden Bestrahlungsvorgangs alle Zielbestrahlungsvorgänge sind; bei allen Zielbestrahlungsvorgängen Bewegungsrichtungen (M) von Lasern (L), die sich auf dem Solarzellensubstrat (110) bewegen, eine Bewegungsrichtungsmenge darstellen;
wobei es in der Bewegungsrichtungsmenge eine Vielzahl von Bewegungsrichtungen, die einander gleich sind, oder eine Vielzahl von Bewegungsrichtungen, die einander entgegensetzt sind, gibt; oder wobei es in der Bewegungsrichtungsmenge eine Vielzahl von Bewegungsrichtungen, die sich miteinander schneiden, gibt.

3. Verfahren zur Herstellung einer Solarzelle nach Anspruch 1, wobei der Laser (L), der bei einem der kontinuierlichen sich bewegenden Bestrahlungsvorgänge mit Ausnahme des ersten kontinuierlichen sich bewegenden Bestrahlungsvorgangs verwendet wird, als ein roter Laser ausgelegt ist.

4. Verfahren zur Herstellung einer Solarzelle nach Anspruch 1, wobei eine bei jedem der kontinuierlichen sich bewegenden Bestrahlungsvorgänge ausgebildete Bestrahlungsregion (W) dieselbe Region ist.

5. Verfahren zur Herstellung einer Solarzelle nach Anspruch 1, wobei es unter den durch alle der kontinuierlichen sich bewegenden Bestrahlungsvorgänge ausgebildeten Bestrahlungsregionen (W) eine Vielzahl von verschiedenen Bestrahlungsregionen gibt.

6. Verfahren zur Herstellung einer Solarzelle nach Anspruch 5, wobei es unter allen der Bestrahlungsregionen (W) eine erste Zielregion (Z1) gibt; und
die erste Zielregion (Z1) basierend auf einer Position der ersten anfänglichen Elektrode (e1) bestimmt wird.

7. Verfahren zur Herstellung einer Solarzelle nach Anspruch 5, wobei es unter allen der Bestrahlungsregionen (W) eine zweite Zielregion (Z2) gibt;
die zweite Zielregion (Z2) basierend auf einer entsprechenden Region auf einer Seitenoberfläche des Solarzellensubstrats (110), auf der sich die erste anfängliche Elektrode (e1) befindet, bestimmt wird und die entsprechende Region mindestens eine von einer schlecht gesinterten Region der ersten anfänglichen Elektrode (e1) und einer Randregion des Solarzellensubstrats (110) umfasst.

8. Verfahren zur Herstellung einer Solarzelle nach einem der Ansprüche 1 bis 7, wobei eine bei jedem der kontinuierlichen sich bewegenden Bestrahlungsvorgänge ausgebildete Bestrahlungsregion (W) sich kontinuierlich erstreckt oder sich diskontinuierlich erstreckt.

9. Verfahren zur Herstellung einer Solarzelle nach Anspruch 1, wobei die Anzahl der Male, die der Laser (L) gesteuert wird, um die kontinuierliche sich bewegende Bestrahlung auf dem Solarzellensubstrat (110) durchzuführen, zwei Male beträgt.

10. Verfahren zur Herstellung einer Solarzelle nach einem der Ansprüche 1 bis 9, wobei das Solarzellensubstrat (110) eine Basis (111), eine dotierte Schicht (112), eine erste Passivierungsschicht (113), eine Tunnelschicht (114), eine dotierte elektrisch leitfähige Schicht (115) und eine zweite Passivierungsschicht (116) umfasst;
wobei die Basis (111) Dotierelemente darin aufweist; die Basis (111) eine erste Oberfläche (m1) und eine zweite Oberfläche (m2) aufweist; die dotierte Schicht (112) und die erste Passivierungsschicht (113) aufeinanderfolgend auf der ersten Oberfläche (m1) der Basis (111) angeordnet sind; und die Tunnelschicht (114), die dotierte elektrisch leitfähige Schicht (115) und die zweite Passivierungsschicht (116) aufeinanderfolgend auf der zweiten Oberfläche (m2) der Basis (111) angeordnet sind.

11. Verfahren zur Herstellung einer Solarzelle (100) nach einem der Ansprüche 1 bis 10, wobei das Steuern des Lasers (L), um die kontinuierliche sich bewegende Bestrahlung auf dem Solarzellensubstrat (110) durchzuführen, und das Durchführen der lasergestützten Sinterbehandlung an der ersten anfänglichen Elektrode (e1), um die erste Elektrode (E1) auszubilden und die Solarzelle (100) zu erhalten, Folgendes umfassen:
Bereitstellen einer Laservorrichtung (Q), wobei sich die Laservorrichtung (Q) an einer Seite des Solarzellensubstrats (110) in der Dickenrichtung (F₁) des Solarzellensubstrats (110) befindet und entgegengesetzt zu einer zentralen Region des Solarzellensubstrats (110) angeordnet ist; und
Steuern der Laservorrichtung (Q), um sich so zu drehen, dass eine sich bewegende Bestrahlungsregion des von der Laservorrichtung (Q) emittierten Lasers (L) mindestens einen Abschnitt des Solarzellensubstrats (110) bedeckt, um die lasergestützte Sinterbehandlung an der ersten anfänglichen Elektrode (e1) durchzuführen, um die erste Elektrode (E1) auszubilden.

## Revendications

1. Procédé de fabrication de cellule solaire (100), **caractérisé en ce qu'**il comprend :
la fourniture d'un substrat de cellule solaire (110) ;
la formation, par un procédé de traitement thermique de métallisation, d'une première électrode initiale (e1) sur le substrat de cellule solaire (110) ; et
le contrôle d'un laser (L) pour effectuer une irradiation mobile continue sur le substrat de cellule solaire (110), et effectuer un traitement de frittage assisté par laser sur la première électrode initiale (e1) pour former une première électrode (E1) et obtenir la cellule solaire (100) ;
dans lequel le nombre de fois où le laser (L) est contrôlé pour effectuer l'irradiation mobile continue sur le substrat de cellule solaire (110) est multiple ;
la direction de déplacement (M) du laser (L) dans un premier processus d'irradiation mobile continue et la direction d'extension longitudinale (F3) de la première électrode (E1) sont parallèles entre elles ; et
il existe un processus d'irradiation cible parmi tous les processus d'irradiation mobile continue, et dans le processus d'irradiation cible, une direction de déplacement (M) du laser (L) se déplaçant sur le substrat de cellule solaire (110) et une direction d'extension longitudinale (F₃) de la première électrode (E1) se croisent, et la direction de déplacement (M) du laser (L) se déplaçant sur le substrat de cellule solaire (110) et la direction d'extension longitudinale (F₃) de la première électrode (E1) sont perpendiculaires à une direction d'épaisseur (F₁) du substrat de cellule solaire (110).

2. Procédé de fabrication de cellule solaire selon la revendication 1, dans lequel le nombre de fois où le laser (L) est contrôlé pour effectuer l'irradiation mobile continue sur le substrat de cellule solaire (110) est au moins de trois ; les processus d'irradiation mobile continue autres que le premier processus d'irradiation mobile continue sont tous des processus d'irradiation cibles ; dans tous les processus d'irradiation cibles, les directions de déplacement (M) des lasers (L) se déplaçant sur le substrat de cellule solaire (110) constituent un ensemble de directions de déplacement ;
dans lequel, dans l'ensemble des directions de déplacement, il existe une pluralité de directions de déplacement identiques ou une pluralité de directions de déplacement opposées ; ou dans l'ensemble des directions de déplacement, il existe une pluralité de directions de déplacement qui se croisent.

3. Procédé de fabrication de cellules solaires selon la revendication 1, dans lequel le laser (L) utilisé dans l'un quelconque des processus d'irradiation mobile continue autre que le premier processus d'irradiation mobile continue est configuré comme un laser rouge.

4. Procédé de fabrication de cellule solaire selon la revendication 1, dans lequel la région d'irradiation (W) formée dans chacun des processus d'irradiation mobile continue est la même région.

5. Procédé de fabrication de cellule solaire selon la revendication 1, dans lequel il existe une pluralité de régions d'irradiation différentes parmi les régions d'irradiation (W) formées par tous les processus d'irradiation mobile continue.

6. Procédé de fabrication de cellule solaire selon la revendication 5, dans lequel il existe une première région cible (Z1) parmi toutes les régions d'irradiation (W) ; et
la première région cible (Z1) est déterminée sur la base de la position de la première électrode initiale (e1).

7. Procédé de fabrication de cellule solaire selon la revendication 5, dans lequel il existe une seconde région cible (Z2) parmi toutes les régions d'irradiation (W) ;
la seconde région cible (Z2) est déterminée sur la base d'une région correspondante sur une surface latérale du substrat de cellule solaire (110) où se trouve la première électrode initiale (e1), et la région correspondante comprend au moins une région mal frittée de la première électrode initiale (e1) et une région de bord du substrat de cellule solaire (110).

8. Procédé de fabrication de cellule solaire selon l'une quelconque des revendications 1 à 7, dans lequel une région d'irradiation (W) formée par chacun des processus d'irradiation mobile continue est étendue de manière continue ou discontinue.

9. Procédé de fabrication de cellule solaire selon la revendication 1, dans lequel le nombre de fois où le laser (L) est contrôlé pour effectuer l'irradiation mobile continue sur le substrat de cellule solaire (110) est de deux.

10. Procédé de fabrication de cellule solaire selon l'une quelconque des revendications 1 à 9, dans lequel le substrat de cellule solaire (110) comprend une base (111), une couche dopée (112), une première couche de passivation (113), une couche tunnel (114), une couche conductrice dopée (115) et une seconde couche de passivation (116) ;
dans lequel la base (111) comporte des éléments dopants ; la base (111) possède une première surface (m1) et une seconde surface (m2) ; la couche dopée (112) et la première couche de passivation (113) sont disposées successivement sur la première surface (m1) de la base (111) ; et la couche tunnel (114), la couche conductrice dopée (115) et la seconde couche de passivation (116) sont disposées successivement sur la seconde surface (m2) de la base (111).

11. Procédé de fabrication de cellule solaire (100) selon l'une quelconque des revendications 1 à 10, dans lequel le contrôle du laser (L) permet de réaliser l'irradiation mobile continue du substrat de cellule solaire (110), et la réalisation du traitement de frittage assisté par laser sur la première électrode initiale(e1) permet de former la première électrode (E1) et obtenir la cellule solaire (100) comprennent :
la fourniture d'un dispositif laser (Q), le dispositif laser (Q) étant situé sur un côté du substrat de cellule solaire (110) dans la direction de l'épaisseur (F₁) du substrat de cellule solaire (110) et disposé en face d'une région centrale du substrat de cellule solaire (110) ; et
le contrôle du dispositif laser (Q) pour qu'il tourne, de sorte qu'une région d'irradiation mobile du laser (L) émise par le dispositif laser (Q) couvre au moins une partie du substrat de cellule solaire (110) pour effectuer le traitement de frittage assisté par laser sur la première électrode initiale (e1) afin de former la première électrode (E1).
